# EUROPEAN PATENT SPECIFICATION

(11) **EP 1 996 648 B1**
(45) Date of publication and mention of the grant of the patent: **09.06.2010**
(21) Application number: 07726880.3
(22) Date of filing: 14.03.2007
(51) Int. Cl.: C08K 3/36, C08K 9/04, C08L 83/00, H01L 31/0216

(54) **PROCESS FOR PREPARING A RUBBER COMPOSITION, RUBBER COMPOSITION OBTAINED THEREFROM, AND USE THEREOF**
VERFAHREN ZUR HERSTELLUNG EINER KAUTSCHUKZUSAMMENSETZUNG, DARAUS GEWONNENE KAUTSCHUKZUSAMMENSETZUNG UND VERWENDUNG
PROCÉDÉ SERVANT À PRÉPARER UNE COMPOSITION DE CAOUTCHOUC, COMPOSITION DE CAOUTCHOUC OBTENUE À PARTIR DE CELUI-CI ET UTILISATION DE CELUI-CI

(30) Priority: 17.03.2006 EP 06111326; 27.03.2006 US 785983 P
(43) Date of publication of application: 03.12.2008
(73) Proprietor: Akzo Nobel N.V., 6824 BM Arnhem (NL)
(72) Inventor: VENDERBOSCH, Rudolf Anthonius Maria, NL-6922 JL Duiven (NL); SCHOMAKER, Elwin, NL-6828 EH Arnhem (NL); TALMA, Auke Gerardus, NL-7437 PM Bathmen (NL)
(74) Representative: Schalkwijk, Pieter Cornelis
(86) International application number: PCT/EP2007/052385
(87) International publication number: WO 2007/107485

(56) References cited:
- EP-A- 0 982 268
- GB-A- 1 507 745
- US-A1- 2003 020 090
- US-B1- 6 329 460

## Description

The invention relates to a process for preparing rubber compositions comprising rubber and inorganic oxygen-containing particulate material modified with a coupling agent.

Such processes are known from US 6,509,423, in which the preparation of a silicone rubber composition comprising an organopolysiloxane, an organo-hydrogen silane, an inorganic filler, and a hydrosilylation catalyst is disclosed. The inorganic filler generally has an average particle size of from 0.1 to 500 µm. These inorganic fillers may also be treated with an organosilicon compound.

In US 6,830,811 a process for preparing hydrophobic partially aggregated colloidal silica is described. Obtained with this process is a suspension in an aqueous/organic solvent medium of a colloidal silica modified with an organosilane. After modification of the silica, water is removed, and from the subsequent suspension the remaining solvent is removed by evaporation or spray-drying. The thus obtained aggregates of hydrophobic colloidal silica can be used in silicones.

GB 1,507,745 describes metal silicate-treated minerals and organosilane-modified metal silicate-treated minerals which are receptive toward silane coupling agents. It furthermore describes a process for producing these fillers, and polymer compositions containing the treated fillers and silane coupling agents.

US 6,329,460 describes a resin composition comprising a resin, an inorganic filler, and a polysiloxane. It furthermore describes a surface-treated inorganic solid particle obtained by surface treating the inorganic solid particle with the polysiloxane composition.

EP 0 982 268 discloses a method for making hydrophobic non-aggregated colloidal silica suitable for use as fillers in silicone rubber compositions. To this end, an aqueous suspension of hydrophilic non-aggregated colloidal silica is reacted with at least one organosilicon compound to effect hydrophobing of the colloidal silica. The hydrophobic colloidal silica is subsequently obtained in its dry form before the dry solids are added to the silicone liquids.

The disadvantage of the processes of the prior art is that agglomerates of modified colloidal silica are added to the rubber precursor, rendering, upon curing of the resin precursor, a rubber composition wherein the colloidal silica is not homogeneously distributed. This inhomogeneous distribution causes the rubber composition to have non-optimal physical properties.

It is an object of the present invention to provide an improved process for preparing rubber compositions. A further object is to provide a rubber composition with improved physical properties.

This object is achieved with a process for preparing a rubber precursor or a rubber composition comprising a modified inorganic oxygen-containing particulate material, comprising the steps of:
a) preparing a mixture of the modified inorganic oxygen-containing particulate material and a first solvent; and
b1) contacting the mixture with a rubber precursor comprising at least one polymer and optionally a second solvent; or
b2) contacting the mixture with a monomer composition comprising at least one monomer and optionally a second solvent, and polymerizing the monomer(s) to form the rubber precursor;
c) optionally cross-linking the rubber precursor in the presence of a cross-linking agent to form a rubber composition; and
d) optionally removing the first and/or second solvents before, during or after any of the steps b1), b2), and c).

The use of the mixture of the modified particulate material and the first solvent (step a)) allows the particulate material to be already well dispersed before the mixture is combined with the rubber precursor or its monomers. In this way, the particulate material can be well dispersed in the rubber precursor with no or minimal agglomeration. In contrast, the prior art processes, e.g. as described in EP 0 982 268, use hydrophobic silica in the solid form, which generally causes agglomerates of the modified silica to be present in the final silicone composition. This agglomeration may necessitate a grinding or milling step in conventional processes, rendering them more complex and economically less attractive compared to the process of the invention.

Moreover, the mixture of the modified particulate material and the first solvent in step a) can be easily handled, as it generally has a relatively low viscosity, and also enables easy mixing into the rubber precursor of step b1), or the monomer(s) thereof of step b2). Generally, during the process of the invention the first solvent will evaporate to a large extent or even completely without a separate evaporation step being needed, and without void formation in the final rubber composition, in particular when the rubber is a silicone rubber.

With the process of the present invention a rubber composition comprising modified inorganic oxygen-containing particulate material is obtained with improved mechanical properties such as durometer hardness, tensile strength, elongation, modulus, tear strength, and improved optical properties.

The process of the invention comprises two alternative steps b1) and b2). In step b1) the first solvent/particulate material mixture is added to the rubber precursor without a reaction taking place between the modified particulate material and the rubber precursor.

In step b2) the mixture of step a) is added to at least one monomer of the rubber precursor, which monomer(s) is/are subsequently polymerized.

In one embodiment of this process, the inorganic oxygen-containing particulate material is modified with a coupling agent comprising a first functional group reactive with the particulate material and a second functional group reactive with the monomer(s) and/or the rubber precursor. In such a case, the second functional group may react with the monomer(s) during polymerisation thereof, causing the particulate material to be chemically linked to the rubber precursor. Alternatively, the second functional group may react with the rubber precursor upon curing of the precursor in step c), causing the modified particulate material to be chemically linked to the rubber composition.

The first and second solvents used in the process of the invention can be any solvent suitable for use in this process and known to the man skilled in the art. Such a first and/or second solvent may be the same or different and preferably is a solvent compatible with the modified particulate material, i.e. a solvent in which the particulate material remains well dispersed into discrete and non-aggregated particles, as well as with the rubber precursor, its monomer and/or the resulting rubber composition.

The first and/or second solvents include alcohols, such as methanol, ethanol, isopropanol, and n-butanol; ketones, such as methyl amyl ketone, methyl ethyl ketone, methyl isobutyl ketone, and cyclohexanone; esters, such as ethyl acetate and butyl acetate; unsaturated acrylic esters, such as butyl acrylate, methyl methacrylate, and trimethylol propane triacrylate; aromatic hydrocarbons, such as toluene and xylene; and ethers, such as dibutyl ether, tetrahydrofuran (THF), and methyl tert-butyl ether (MTBE).

In a preferred embodiment of the aforementioned process, the first and/or second solvents are an alkoxylated alcohol according to the formula 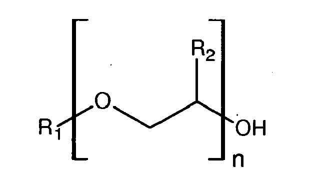 wherein R₁ is a C₁-C₄ alkyl, R₂ is hydrogen or methyl, and n is an integer from 1 to 5.

Examples of such alkoxylated alcohols are ethylene glycol monomethyl ether, ethylene glycol monoethyl ether, ethylene glycol mono n-propyl ether, ethylene glycol monoisopropyl ether, ethylene glycol monobutyl ether, ethylene glycol mono t-butyl ether, ethylene glycol monohexyl ether, ethylene glycol monophenyl ether, diethylene glycol monomethyl ether, diethylene glycol monoethyl ether, diethylene glycol mono n-propyl ether, diethylene glycol monoisopropyl ether, diethylene glycol monobutyl ether, propylene glycol monomethyl ether, propylene glycol monoethyl ether, propylene glycol monopropyl ether, propylene glycol monoisopropyl ether, propylene glycol monobutyl ether, propylene glycol mono t-butyl ether, propylene glycol monohexyl ether, propylene glycol monophenyl ether, dipropylene glycol monomethyl ether, dipropylene glycol monoethyl ether, dipropylene glycol mono n-propyl ether, dipropylene glycol monoisopropyl ether, and dipropylene glycol monobutyl ether. Of these alcohols ethylene glycol monomethyl ether and ethylene glycol monoethyl ether are less preferred, because they are teratogenic and may cause health problems.

The most preferred alkoxylated alcohols are propylene glycol monomethyl ether and propylene glycol monoethyl ether. Solvents are available, e.g., from Shell (Oxitol/Proxitol) and Dow (Dowanol) and Union Carbide (Carbitol/Cellosolve).

It is also envisioned to use two or more alkoxylated alcohols in the process of the invention.

In the context of the present application the term "modified inorganic oxygen-containing particulate material" refers to particulate material having on average a dimension of between 1 and 1,000 nm in at least in one direction, which material is modified with a coupling agent.

Typically, the inorganic oxygen-containing particulate materials of the invention have a number average particle diameter, as determined using a dynamic light scattering method, of between 1 and 1,000 nm, a solids content of 10 to 50 wt%. Preferably, the number average particle diameter is between 1 and 150 nm, and most preferably the number average particle diameter is between 1 and 100 nm. It is envisaged that the inorganic oxygen-containing particulate material according to the invention may comprise bimodal or polymodal particle size distributions.

The inorganic oxygen-containing particulate material can be any particulate material known to the man skilled in the art. It is envisioned that the inorganic particulate material of the present invention may already be modified, e.g. it may contain organic constituents or be encapsulated in a second inorganic material, before being modified according to the processes of the invention. The inorganic oxygen-containing particulate material generally is selected from oxides, hydroxides, calcium compounds, zeolites, and talc.

Examples of suitable oxides and hydroxides are silica (i.e. silicon dioxide), alumina, aluminium trihydrate, titanium dioxide, zinc oxide, iron oxide, zirconium oxide, cerium oxide, antimony oxide, bismuth oxide, cobalt oxide, dysprosium oxide, erbium oxide, europium oxide, indium oxide, indium hydroxide, magnesium oxide, neodymium oxide, nickel oxide, samarium oxide, terbium oxide, tin oxide, tungsten oxide, and yttrium oxide.

Examples of calcium compounds are calcium carbonate and calcium phosphate.

Preferred inorganic oxygen-containing particulate materials are the oxides and hydroxides, and in particular silica, alumina, aluminium trihydrate, titanium dioxide, and zinc oxide.

The most preferred particulate material is silica. Examples of aqueous colloidal silica are Nyacol^{®} ex Akzo Nobel N.V., Snowtex^{®} ex Nissan Chemicals Ltd., and Klebosol^{®} ex Clariant.

The present invention also encompasses the modification of mixtures of two or more of the aforementioned inorganic particulate materials.

Any coupling agent capable of reacting with the inorganic oxygen-containing particulate material can be used in the process of the invention; suitable coupling agents are known to the man skilled in the art. Generally, the coupling agent of the invention comprises at least one element selected from the group consisting of Si, Al, Ti, Zr, B, Zn, Sn, and V. Preferably, the coupling agent comprises at least one element selected from the group consisting of Si, Al, Ti, Zr, and B.

The coupling agent of the invention generally is a coupling agent according to the formula: 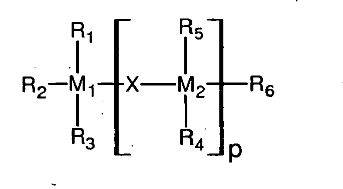 wherein M₁ and M₂ are independently selected from the group consisting of Si, Al, Ti, Zr, and B, and at least one of R₁-R₆ is independently selected from hydroxyl, chlorine, an acetoxy having between 1 and 10 carbon atoms, an alkoxy having between 1 and 20 carbon atoms, an organophosphate comprising two hydrocarbon groups comprising 1 to 20 carbon atoms, and an organopyrophosphate comprising two hydrocarbon groups comprising 1 to 20 carbon atoms, which acetoxy, alkoxy, organophosphate or organopyrophosphate optionally comprises at least one functional group, and the remaining R₁-R₆ are independently selected from hydroxyl, chlorine, a hydrocarbon having between 1 and 10,000 carbon atoms, which hydrocarbon optionally comprises at least one functional group, an acetoxy having between 1 and 5 carbon atoms, and an alkoxy having between 1 and 20 carbon atoms, which alkoxy optionally comprises at least one functional group, siloxane and silazane, which siloxane and/or silazane optionally are ring structures, ladder structures or cage-like structures or form a ring, ladder or cage-like structure with any one of the remaining groups R₁-R₆; and X represents oxygen or, if M₁ and/or M₂ are Si, X represents O, N, S, disulphide, polysulphide, R₇-S₄-R₈ and/or R₇-S₂-R₈, where R₇ and R₈ are independently selected from a hydrocarbon having from 1 to 6 carbon atoms, and p represents an integer from 0 to 50, provided that if M₁ is Al or B, R₃ is absent and/or if M₂ is Al or B, R₅ is absent. The functional group can be any functional group known to the man skilled in the art. Examples of such functional groups are hydroxyl, epoxy, isocyanate, thiol, oligosulphides amine, and halogen.

A combination of two or more of coupling agents can be used in the process of the invention. The coupling agents may be contacted with the inorganic oxygen-containing particulate material as a mixture or separately. The ratio of the coupling agents may vary as desired. It is also envisaged to change the ratio of the coupling agents in time as they are added to the particulate material.

If the inorganic oxygen-containing particulate material is silica, the preferred coupling agent is a silicon-based compound. The silicon-based compound is typically selected from the group consisting of silanes, disilanes, oligomers of silane, silazane, silane-functional silicones, silane-modified resins, and silsesquioxanes. Preferred silicon-based compounds are silanes and silazanes. The silanes suitable for use in the process of the invention are silanes according to formulae I-VI: 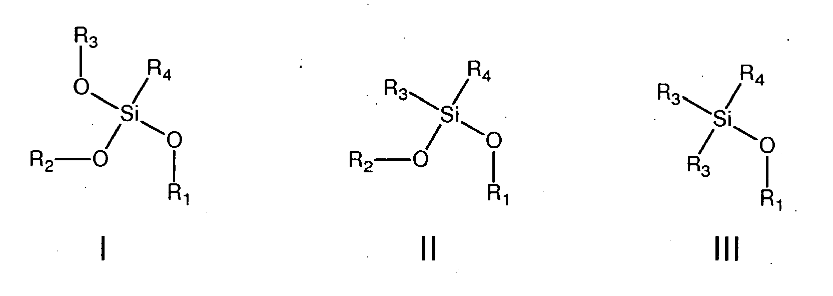 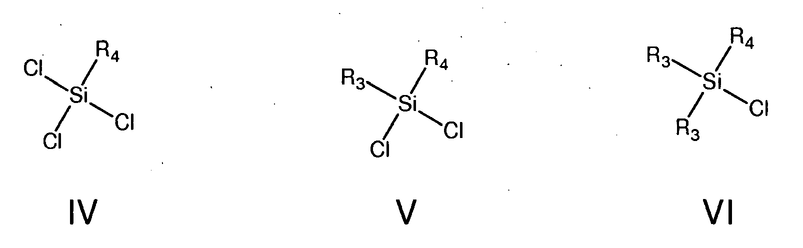 wherein each one of R₁, R₂, R₃, R₄ is independently selected from hydrogen or hydrocarbon having between 1 and 20 carbon atoms, which hydrocarbon optionally comprises at least one functional group. If a silane according to any one of the formulae IV to VI is used in the process of the invention, the ions, and in particular Cl⁻, are preferably removed from the mixture, for example by using ion-exchange techniques. In order to avoid an additional ion removal step, the silanes according to any one of the formulae I-III, are preferred.

Examples of silanes according to the invention are tributyl methoxy silane, dibutyl dimethoxy silane, butyl trimethoxy silane, dodecyl trimethoxy silane, trimethyl chlorosilane, tributyl chlorosilane, dimethyl dichlorosilane, dibutyl dichlorosilane, methyl trichlorosilane, butyl trichlorosilane, octyl trichlorosilane, dodecyl trichlorosilane, methyl trimethoxy silane (Dynasylan^{®} MTMS), methyl triethoxy silane (Dynasylan^{®} MTES), propyl trimethoxy silane (Dynasylan^{®} PTMO), propyl triethoxy silane (Dynasylan^{®} PTEO), isobutyl trimethoxy silane (Dynasylan^{®} IBTMO), isobutyl triethoxy silane (Dynasylan^{®} IBTEO), octyl trimethoxy silane (Dynasylan^{®} OCTMO), octyl triethoxy silane (Dynasylan^{®} OCTEO), hexadecyl trimethoxy silane (Dynasylan^{®} 9116), phenyl trimethoxy silane (Dynasylan^{®} 9165), phenyl triethoxy silane (Dynasylan^{®} 9265) 3-glycidyloxypropyl trimethoxy silane (Dynasylan^{®} GLYMO), glycidyloxypropyl triethoxy silane (Dynasylan^{®} GLYEO), 3-mercapto trimethoxy silane (Dynasylan^{®} MTMO), 3-mercaptopropyl methyl dimethoxy silane (Dynasylan^{®} 3403), 3-methacryloxypropyl trimethoxy silane (Dynasylan^{®} MEMO), vinyl triethoxy silane (Dynasylan^{®} VTEO), vinyl trimethoxy silane (Dynasylan^{®} VTMO), vinyl tris(2-methoxyethoxy)silane (Dynasylan^{®} VTMOEO), acetoxy propyl trimethoxy silane, methyl triacetoxy silane, 3-acryloxy propyl trimethoxy silane, 3-acryloxypropyl dimethyl methoxy silane, allyl trimethoxy silane, allyl triethoxy silane, dimethyl diethoxy silane, dimethyl dimethoxy silane, dimethyl ethoxy silane, n-hexadecyl triethoxy silane, 3-mercaptopropyl triethoxy silane, methyl dodecyl diethoxy silane, methyl-n-octadecyl diethoxy silane, methyl phenyl diethoxy silane, methyl phenyl dimethoxy silane, n-octadecyl triethoxy silane, n-octadecyl trimethoxy silane, phenyl dimethyl ethoxy silane, trimethyl ethoxy silane, trimethyl methoxy silane, vinyl methyl diethoxy silane, octanethioic acid, S-(triethoxysilyl) propyl ester, bis(3-triethoxysilylpropyl) tetrasulphide (Si69^{®} ex Degussa), bis(3-triethoxysilylpropyl) disulphide, gamma-mercaptopropyl trimethoxysilane (SiSiB^{®} PC2300 ex PCC), and 3-octanoylthio-1-propyl triethoxysilane (NXT^{™} ex GE). Further examples of silane coupling agents can be gleaned from WO 99/09036, which silane coupling agents are incorporated herein by reference.

It is further envisaged that the silane used in the process of the invention is a mixture of two or more silanes according to any one of the formulae I-VI. Examples of suitable disilanes are bis(2-hydroxyethyl)-3-aminopropyl-triethoxy silane, 1,2-bis(trimethoxysilyl)ethane, bis(trimethoxyl silyl ethyl)benzene, and 1,6-bis(trimethoxyl silyl)hexane.

Examples of suitable oligomers of silane are vinyl trimethoxy silane oligomer (Dynasylan^{®} 6490), vinyl triethoxy silane oligomer (Dynasylan^{®} 6498).

Examples of suitable silazanes are hexamethyl disilazane (Dynasylan^{®} HMDS), tetramethyl disilazane, dimethyl cyclic silazane, 1,1,1,2,3,3,3-heptamethyl disilazane, and N-methyl silazane resin (PS117 ex Petrarch)

Examples of suitable siloxanes are 1,1,3,3-tetramethyl-1,3-diethoxy disiloxane, silanol-terminated polydimethylsiloxane (e.g. PS 340, PS 340.5, PS 341, PS 342.5 and PS 343 ex Fluorochem), diacetoxy-functionalised polydimethyl siloxane (PS 363.5 ex Fluorochem), methyldiacetoxy-functionalised polydimethyl siloxane (PS 368.5 and PS 375 ex Fluorochem), dimethylethoxy-terminated polydimethyl siloxane (PS 393 ex Fluorochem), and dimethyl-methoxy-terminated polydimethyl siloxane (PS 397 ex Fluorochem).

The silane-modified resins generally are polymers containing mono-, di- or trialkoxysilyl moieties or their hydroxysilyl, acetoxysilyl or chlorosilyl counterparts, which can be prepared by introducing silicon-containing monomers during polymerisation or by modifying the resin, as will be apparent to a man skilled in the art. Preferred silane-modified resins are polymers containing mono-, di- or trialkoxysilyl moieties, because they are more stable and do not require any further processing steps to remove undesirable byproducts like acids and chlorides. Examples of such silane-modified resins are trimethoxysilyl-modified polyethylenimine (PS 076 ex Fluorochem), methyldimethoxysilyl-modified polyethylenimine (PS 076.5 ex Fluorochem), N-triethoxysilylpropyl-o-polyethylene-oxideurethane (PS 077 ex Fluorochem), and methyldiethoxysilyl-modified 1,2-polybutadiene (PS 078.8 ex Fluorochem). Examples of suitable silsesquioxanes are polymethyl silsesquioxane (PR 6155 ex Fluorochem), polyphenyl propyl silsequioxane (PR 6160 ex Fluorochem), and OH-functional polyphenyl propyl silsesquioxane (PR 6163 ex Fluorochem). Other coupling agents preferred in the process of the invention are organo-metallates of titanium, aluminium, boron, and zirconium.

Examples of titanium-containing coupling agents are isopropyl isostearoyl titanate, isopropyl dimethacryl triisostearoyl titanate, isopropyl dimethacryl isostearoyl titanate, tetraisopropyl di((dioctyl) phosphito) titanate, tetra(2,2-diallyloxymethyl)butyl di((ditridecyl) phosphito) titanate, isopropyl tri((dioctyl) pyrophosphate) titanate, isopropoxy triisostearoyl titanate, di((dioctyl) pyrophosphate) oxoethylene titanate, di((dioctyl) phosphate) ethylene titanate, di((dioctyl) pyrophosphate) ethylene titanate, tetraoctyl titanate di(ditridecyl) phosphite, titanium(IV) 2,2-(bis 2-propenolatomethyl) butanolato, tris(dioctyl) pyrophospato-O, and dialkoxy bis(triethanolamine) titanate.

Examples of aluminium-containing coupling agents are diisopropyl acetoalkoxy aluminate, isopropyl diisostearoyl aluminate, and isopropyl dioctyl phosphate aluminate.

Examples of boron-containing coupling agents are trimethyl borate (TMB ex Semichem), triethyl borate (TEB ex Semichem), and tripropyl borate. Examples of zirconium-containing coupling agents are isopropyl triisostearoyl zirconate, butyl triisostearoyl zirconate, butyl trioleyl zirconate, isopropyl trilinoleyl zirconate, di(cumyl)phenyl oxoethylene zirconate, di(cumyl)phenyl dibutyl zirconate, and tri(cumyl)phenyl propyl zirconate.

In one embodiment of the process of the invention, the inorganic oxygen-containing particulate material which has been modified with at least one of the above coupling agents is subsequently modified with a further coupling agent or with a compound capable of reacting with the coupling agent attached to the particulate material. For example, the modified particulate material is treated with hexamethyl disilazane (HMDS), which renders a modified oxygen-containing particulate material that is more hydrophobic and consequently more compatible with hydrophobic matrices.

The rubber precursor prepared with the process of the invention is a precursor of rubber which upon curing or vulcanisation can be converted into the rubber. Such rubber precursors as well as the rubbers formed thereof are known to the man skilled in the art.

Examples of rubbers include natural rubber (NR), styrene-butadiene rubber (SBR) polyisoprene (IR), polybutadiene (BR), polyisobutylene (IIR), halogenated polyisobutylene, nitrile butadiene rubber (NBR), hydrogenated nitrile butadiene rubber (HNBR), styrene-isoprene-styrene (SIS) and similar (hydrogenated) styrenic block copolymers (SBS, hydrogenated SIS, hydrogenated SBS), poly(epichlorohydrin) rubbers (CO, ECO, GPO), silicon rubbers (Q), chloroprene rubber (CR), ethylene propylene rubber (EPM), ethylene propylene diene rubber (EPDM), fluorine rubbers (FKM), ethylenevinylacetate rubber (EVA), polyacrylic rubbers (ACM), polynorbornene (PNR), polyurethanes, and polyester/ether thermoplastic elastomers. Preferred rubbers are natural rubber, SBR, EPDM, polyurethane, and silicone rubber.

In the context of the present application the term "rubber composition" refers to a composition comprising rubber and the modified inorganic oxygen-containing particulate material, and optionally other additives.

The rubber precursor of the invention may optionally be cured in the presence of a cross-linking agent to form the rubber composition. Curing processes of rubber precursors are known to the skilled man. The cross-linking agent can be any cross-linking agent suitably used for curing of the rubber precursors. Such cross-linking agents are known in the art and include a Group VIII metal (such as Pt and Ru) complex, a supported Group VIII metal catalyst, a sulphur-containing curing agent, a peroxide, or combinations thereof.

In one embodiment of the invention the rubber is a silicone rubber. The production of silicone rubbers is generally known to a person skilled in the art, and is for example described in Chapters 3, 4, and 5 in "Silicones", Kirk Othmer Encyclopedia of Chemical Technology, John Wiley & Sons, Inc., online posting date: December 20, 2002. In essence, the production of silicones proceeds via the polymerisation of monomers to form a silicone precursor, after which the silicone precursors are cross-linked to form the silicone. The silicone precursors used in the process of the invention are known to the man skilled in the art. It is noted that the silicone precursor preferably is liquid, so that the mixture of the modified particulate material and the first solvent can be easily mixed with the precursor in order to obtain a homogeneous and uniform distribution of the particulate material throughout the silicone precursor.

In one embodiment of the process of the invention the silicone precursor obtained in either of the steps b1) and b2) is cured to form the silicone, e.g. silicone rubber or silicone foam rubber. Such curing typically brings about the formation of a three-dimensional network structure consisting of cross-linked polydiorganosiloxane chains. Curing generally proceeds via peroxide-induced free-radical processes, via hydrosilylation addition processes using a Group VIII all metal (such as Pt and Ru) complex or a supported Group VII metal catalyst, or via condensation reactions. Examples of each of these curing processes can be found in Chapter 5: "Silicone Network Formation", "Silicones", Kirk Othmer Encyclopedia of Chemical Technology, John Wiley & Sons, Inc., online posting date: December 20, 2002. Upon curing of the silicone precursor, silicone rubber or rubber foams can be obtained.

It is envisaged to use the inorganic oxygen-containing particulate material which is modified with a coupling agent comprising a first functional group reactive with the particulate material and a second functional group reactive with the silicone precursor during the curing step either as such (e.g., as the product of step b1)) or as a particulate material already linked to the silicone precursor (e.g., as products of step b2)). In this way, the second functional groups of the coupling agents attached to the particulate material may also react with the silicone precursor so as to form a link between two or more silicone precursor chains. The resulting silicone rubber or foam comprises modified particulate material which is chemically linked thereto.

Suitable examples of the above-mentioned second functional groups are hydroxyl, vinyl, chloride, hydride, thiol, acrylate, methacrylate, or acetoxy.

The invention further pertains to a process for preparing a rubber precursor or a rubber composition comprising the steps of:
a) preparing a mixture of an aqueous suspension of inorganic oxygen-containing particulate material and an alkoxylated alcohol according to the formula 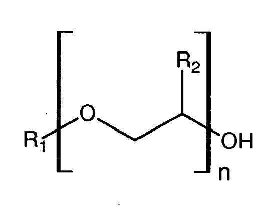 wherein R₁ is a C₁-C₄ alkyl, R₂ is hydrogen or methyl, and n is an integer from 1 to 5;
b) optionally contacting the mixture with at least one monomer and optionally polymerising the monomer(s) to form the rubber precursor, and/or with at least one rubber precursor;
c) contacting at least one coupling agent with the mixture and modifying the inorganic oxygen-containing particulate material at least partially;
d) optionally contacting at least one monomer with the resulting mixture and polymerising the monomer(s) to form a rubber precursor, or contacting at least one rubber precursor with the resulting mixture;
e) optionally curing the rubber precursor(s); and
wherein optionally water and/or the alkoxylated alcohol are removed at least partially from the mixture before, during or after any of the preceding steps. In a particular embodiment water is removed prior to step b) and/or step d).

The process of the invention provides a modified inorganic oxygen-containing particulate material which has a good compatibility with resins. Due to the good compatibility of the solvent with water, the particulate material, and the rubber precursor and/or its monomers, a stable dispersion of the modified particulate material in the rubber precursor can be achieved. A further advantage of the process of the invention is that the process generally requires fewer steps and less solvent, enabling a higher yield of inorganic particulate material per unit volume, rendering the process more efficient than conventional processes for making modified particulate material. The utilisation of the alkoxylated alcohol causes a more efficient removal of water from the mixture comprising inorganic oxygen-containing particulate material, alkoxylated alcohol, and water. The alkoxylated alcohol further has the advantage that it is compatible with most rubber precursors, rendering unnecessary the use of other solvents in which the resin is dissolved (more) easily. Consequently, the process of the invention generally is simpler, more attractive economically, and more environmentally friendly than conventional processes.

In the process of the invention water, in particular water originating from the aqueous suspension, and/or the first and/or second solvents can be removed at any time during the process. In one embodiment water, the first and/or the second solvent are removed prior to the curing step in order to avoid water or solvent being trapped inside the rubber. The removal can be performed by any method known in the art, such as evacuation, distillation, distillation in combination with evacuation, and using a membrane, e.g. an ultrafiltration membrane, which is capable of selectively removing water from the mixture.

In certain applications the presence of water can cause undesirable deterioration of the rubber precursor or its monomer(s); in such applications the quantity of water in the mixture of step a) - if the monomer(s) and/or the rubber precursor used in step b) are sensitive to water - or c) generally is reduced to less than 5 percent by weight (wt%) of water, based on the total weight of the mixture resulting in step a) or c), preferably less than 2 wt%, and most preferably less than 1 wt% of water.

In a further preferred embodiment of the present invention, an aqueous suspension of inorganic oxygen-containing particulate material, and in particular an aqueous silica, which is de-ionised is used. "De-ionised" means that any free ions such as anions like Cl⁻ and cations such as Mg²⁺ and Ca²⁺ are removed from the aqueous suspension to a desirable concentration using techniques known to the man skilled in the art, such as ion-exchange techniques. "Free ions" refers to ions that are dissolved in the solvent(s) and can freely migrate through the mixture. The amount of free ions typically is less than 10,000 ppm, preferably less than 1,000 ppm, and most preferably less than 500 ppm.

The present invention further pertains to a process for preparing a rubber precursor or a rubber composition comprising the steps of:
a) preparing a mixture of an aqueous suspension of inorganic oxygen-containing particulate material and a first solvent;
b) adding at least one monomer or a rubber precursor, wherein at least one monomer is a coupling agent;
c) polymerising the monomer(s) to form a rubber precursor;
d) optionally curing the rubber precursor; and
wherein optionally water and/or the first solvent are removed at least partially from the mixture before, during or after any of the preceding steps.

The first solvent can be any solvent compatible with water and the modified particulate material, i.e. in which the particulate material remains well dispersed into discrete and non-aggregated particles, as well as with the rubber precursor, its monomer and/or the resulting rubber composition. Preferably, the solvent is an alcohol such as methanol, ethanol, isopropanol, and n-butanol, or an alkoxylated alcohol as defined above. The most preferred solvent is the alkoxylated alcohol.

The advantage of this process is that it allows the modification of the inorganic oxygen-containing particulate material and the preparation of the rubber precursor in one step. It is noted that the polymerisation of the monomers generally requires initiation, e.g., by using an initiator such as a peroxide, or by using a catalyst. This allows for modification of the particulate material before the polymerisation is started. Alternatively, the modification and polymerisation can proceed simultaneously.

In a preferred embodiment of this process, the monomer which also acts as a coupling agent comprises a first functional group reactive with the particulate material and a second functional group reactive with the monomer(s) and/or the rubber precursor. Using such a monomer causes the particulate material to be chemically linked to the rubber precursor.

In the context of the present invention the wording "aqueous suspension of inorganic oxygen-containing particulate material" refers to a suspension wherein at least part of the solid particles of the inorganic oxygen-containing particulate material having a dimension of between 1 and 1,000 nm in at least one direction are dispersed in an aqueous medium.

The invention further pertains to rubber compositions comprising rubber and inorganic oxygen-containing particulate material modified with a coupling agent wherein the inorganic oxygen-containing particulate material has a dimension of between 1 and 1,000 nm in at least one direction.

The advantage of the rubber compositions according to the invention is that they exhibit improved durometer hardness and tensile strength, an enhanced elongation and modulus, and an improved tear strength compared to conventional silicones comprising modified particulate material.

These properties are even further improved if the oxygen-containing particulate material is modified with a coupling agent comprising a first functional group reactive with the particulate material and a second functional group reactive with the rubber or with the rubber precursor.

Generally, the amount of modified particulate material present in the rubber composition of the present invention is from 0.1 to 60 wt%, based on the total weight of the rubber composition, preferably the amount is from 0.5 to 50 wt%, and most preferably the amount is from 1 to 30 wt%. It is noted that compared to conventional rubber compositions, the rubber composition of the present invention generally requires less modified particulate material in order to have similar mechanical properties.

The invention further pertains to a masterbatch obtainable by any of the aforementioned processes comprising a rubber precursor and an inorganic oxygen-containing particulate material having a dimension of between 1 and 1,000 nm in at least one direction, which particulate material is modified with a coupling agent, wherein the amount of particulate material is between 5 and 80 wt%, based on the total weight of the masterbatch, and the amount of rubber precursor is between 20 and 95 wt%.

Preferably, the amount of particulate material is between 15 and 75 wt%, based on the total weight of the masterbatch, and the amount of rubber precursor is between 25 and 85 wt%.

Masterbatches are known in the art as highly concentrated additive premixes which can be used in the preparation of rubber compositions. Such masterbatches are contacted with at least one rubber precursor which does not contain the modified particulate material of the invention, so as to form the rubber composition of the invention: The advantage of the masterbatch is that it can be prepared in one location, transported to another location, and used to prepare the final rubber composition.

A preferred embodiment of the masterbatch comprises particulate material modified with a coupling agent comprising a functional group reactive with the particulate material and an organic group reactive with the rubber or with the rubber precursor.

The rubber compositions of the present invention can be suitably applied in tyre manufacture, such as in car tyres including winter tyres, truck tyres, off-the-road tyres, and aircraft tyres, in latex products including gloves, condoms, balloons, catheters, latex thread, foam, carpet backings and rubberised coir and hair, in footwear, in civil engineering products such as bridge bearings, rubber-metal-laminated bearings, in belting and hoses, in non-tyre automotive applications including engine mounts, rubber bearings, seals, grommets, washers, and boots, in wires and cables, and in pipe seals, medical closures, rollers, small solid tyres, mountings for domestic and commercial appliances, rubber balls and tubing, milking inflations, and other agricultural-based applications.

In one embodiment of the invention the modified inorganic oxygen-containing particulate material is used in a rubber composition of tyres, in particular of car tyres. The rubber in the rubber composition can be any rubber conventionally used in tyres. Examples of such rubbers are natural rubber, uncross-linked styrene-butadiene rubber, cross-linked styrene-butadiene rubber, butadiene rubber, vinyl-butadiene rubber, and synthetic rubber. Also mixtures of these rubbers are commonly used.

The rubber composition according to the invention can be used in any part of the tyre where an inorganic filler such as carbon black or precipitated silica is conventionally used. In particular, the rubber composition can be used in the undertread or tread base, the tread, the sidewall, the rim cushion, the innerlayer, the carcass, the bead, and the belt layer. It is also envisaged to use a combination of the modified particulate material of the invention and a conventional inorganic filler such as carbon black or precipitated silica. The use of the modified particulate material enables a reduction of the total amount of inorganic filler in the rubber composition, while maintaining similar or improved mechanical properties.

In a preferred embodiment, the modified inorganic oxygen-containing particulate material is modified with a coupling agent comprising a vulcanisable group. Such a coupling agent can be a silane coupling agent, such as bis(3-triethoxysilylpropyl) tetrasulphide (Si69^{®} ex Degussa), bis(3-triethoxysilylpropyl) disulphide, gamma-mercaptopropyl trimethoxysilane (SiSiB^{®} PC2300 ex PCC), and 3-octanoylthio-1-propyl triethoxysilane (NXT^{™} ex GE).

The advantage of these modified particulate materials is that the time needed to produce a green tyre can be reduced. Moreover, the dimensional stability of the uncured tyre as well as the final tyre will improve.

In conventional processes the precipitated silica is added to the rubber together with a coupling agent like bis(3-triethoxysilylpropyl) tetrasulphide, the rubber composition is allowed to react at elevated temperatures, the ethanol produced is removed, and an uncured tyre is obtained, which is then cured at a higher temperature to cause vulcanisation and to form the tyre. The use of the modified particulate materials of the invention, in particular the particulate materials modified with the coupling agent having a vulcanisable group, in the production of tyres has the advantage that the coupling agent is already attached to the particulate material and no ethanol is formed, rendering a reduction in processing time which may enhance the production rate of green tyres. If a combination of modified particulate material and conventional filler such as precipitated silica is used, a coupling agent may be added separately to the mixture so that it can react with the precipitated silica; the amount of coupling agent generally is lower than the amount used in conventional processes. The modified particulate material may be added to the rubber in the form of a (colloidal) suspension in a suitable solvent (containing no or hardly any water), or it may be added in an extender oil, or as solids. In the case of an extender oil or solids, no solvent has to be removed, leading to a further reduction in processing time and to improved process safety.

If the rubber composition is a silicone composition comprising silicone rubber and the modified particulate material in accordance with the present invention, such a rubber composition can suitably be applied in coating products including pressure-sensitive adhesives, plastic hardcoats, and paper release coatings, in fibre finishing applications including textile and hair care applications, sealants, adhesives, encapsulants, and solar cell units.

The invention further pertains to the use of the rubber composition in accordance with the invention in solar cell units. In a preferred embodiment, the rubber of the rubber composition is a transparent rubber. The transparent rubber is a rubber which is transparent to visible light. Examples of such transparent rubbers are polyurethane, ethylene vinyl-acetate rubber, and silicone rubber. Preferably, the transparent rubber is a silicone rubber. The solar cell unit can be any solar cell unit known in the art. Examples of such solar cell units are crystalline Si solar cells, amorphous silicon solar cells, crystalline silicon thin film solar cells, and compound semiconductor solar cells based on, e.g., CdTe, CulnSe₂, Cu(In, Ga)(Se, S)₂ (so-called CIGS), and Grätzel cells. Further details can be gleaned from F. Pfisterer ("Photovoltaic Cells", Chapter 4: "Types of Photovoltaic Cells," Ullmann's Encyclopedia of Industrial Technology, online posting date: June 15, 2000).

The rubber composition used in solar cell units may serve to connect two juxtaposed layers in the unit. The advantage of the rubber composition of the present invention is its transparency to visible light, which enables application at a position where light travels through the rubber composition before the light reaches the part of the cell where the light is converted into electrical energy. The rubber composition may also serve to connect the solar cell unit to a substrate, e.g. a plate or a roof tile. In such cases the rubber composition does not have to be transparent. Generally, the rubber composition exhibits improved mechanical properties over conventional rubber compositions.

One embodiment of the present invention pertains to a solar cell unit comprising a back electrode, a photovoltaic layer, a front electrode, and a transparent top layer wherein a layer of the rubber composition of the invention is present in between the front electrode and the transparent top layer. As indicated above, the rubber of the rubber composition preferably is a. transparent rubber, and most preferably the rubber is a silicone rubber. The rubber composition serves as an adhesive or binding layer for the transparent top layer and the front electrode. Due to the aforementioned improved mechanical properties, the adhesive power and the tear strength of the rubber composition are increased and the solar cell unit (in use) is capable of better withstanding weather influences or other mechanical forces to which it is to be exposed. Consequently, the life-time of the solar cell unit is increased. Moreover, the rubber composition of the invention is transparent to visible light, which brings about an improved light yield and solar energy recovery as compared to solar cell units comprising a rubber composition with particles having sizes in the range of or exceeding the visible light wavelengths, i.e. between 400 and 800 nm.

Solar cell units comprising a back electrode, a photovoltaic layer, a front electrode, and a transparent top layer are known to the man skilled in the art. Generally, the back electrode, a photovoltaic layer, a front electrode, and a transparent top layer are provided in layers one on top of the other. A more detailed description of such solar cell units can be found in EP 1 397 837 and EP 1 290 736, which specific descriptions of the back electrode, the photovoltaic layer, the front electrode, and the transparent top layer are incorporated herein by reference.

The invention is illustrated by the following examples.

### EXAMPLES

### Example 1

Into a 3-litre three-necked round-bottomed flask equipped with a mechanical stirrer, a thermometer, and a distillation unit 647.0 grams of Nyacol 2034DI (ex Akzo Nobel), containing 222.56 grams of silica, and 970.5 grams of Ethyl Proxitol (ex Shell) were weighed. The temperature was raised to 38°C and the pressure was reduced to 60 mbar in order to distill a water/solvent mixture. During a period of 3 h the pressure was slowly reduced to 40 mbar. Next, the reaction was stopped, resulting in an organosol with a water content of 2.4 wt% as determined with the Karl Fisher method. The solid content was 30.7 wt% of nano-silica (determined in an oven at 140°C until no loss of solvent was observed).

### Example 2

Into a 250-ml four-necked round-bottomed flask equipped with a mechanical stirrer, a dropping funnel, a reflux condenser, and a thermometer 131.51 grams of the organosol of Example 1, containing 40.4 grams of modified nano-silica, were weighed. The temperature was raised to 110°C and next a mixture of 19.08 grams (0.129 mole) of vinyl trimethoxy silane (ex Aldrich), 8.35 grams (0.46 mole) of water, 0.1 gram of Nyacol 2034DI, and 38.16 grams of Ethyl Proxitol was dosed over a period of 100 minutes.

The temperature was next raised to 130°C to distill off volatiles resulting from the silane and a part of the solvent. The remaining solution contained 36.35 wt% of modified nano-silica (determined in an oven at 140°C until no loss of solvent was observed).

### Example 3

The silicone resin used in this Example was Wacker SLM61211#268, a two-component Pt cured silicone resin (ex Wacker) consisting of a component A, which does not contain the Pt catalyst, and a component B containing the Pt catalyst. To component A the organosol of Example 1 was added in varying amounts, viz. 1 wt% , 2 wt%, and 5 wt% based on the total weight of components A and B. Subsequently, component A was mixed with component B, followed by de-aeration in a vacuum oven at room temperature.

Two foils made of ethylene-tetrafluoroethylene copolymer (ETFE; surface modified ETFE ex Asahi) were adhered to each other using the modified silicone resin. The modified silicone resin was then cured in a Bürkle press for 20 minutes at 120°C using 2.5 bar pressure.

As reference served an unmodified silicone produced as described above, except that no organosol of Example 2 was added to component A.

The adhesion and the strength of the silicone rubbers were determined on 10x1 cm² samples using a CECO, Copper Clad Peeltester TA630.

In all cases a cohesive breakage in the silicone resin resulted, but no failure was observed at the silicone ETFE interface. The resulting peel strengths of the different silicone rubber samples are presented in the Table below.

**Table 1**

| Amount of modified colloidal silica | Peel strength |
|---|---|
| (wt%) | (N/cm) |
| 0 | 13±1 |
| 1 | 19±1 |
| 2 | 21±1 |
| 5 | 18±1 |

From the above results it can be concluded that the addition of the organosol of Example 2 results in an improvement in strength.

## Claims

1. Process for preparing a rubber precursor or a rubber composition comprising the steps of:
a) preparing a mixture of the modified inorganic oxygen-containing particulate material and a first solvent; and
b1) contacting the mixture with a rubber precursor comprising at least one polymer and optionally a second solvent; or
b2) contacting the mixture with a monomer composition comprising at least one monomer and optionally a second solvent, and polymerising the monomer(s) to form the rubber precursor;
c) optionally cross-linking the rubber precursor in the presence of a cross-linking agent to form a rubber composition; and
d) optionally removing the first and/or second solvents during or after any of the steps b1), b2), and c),
wherein the first and/or second solvents are alkoxylated alcohols according to the formula 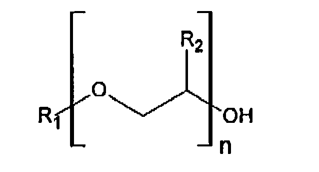 wherein R₁ is a C₁-C₄ alkyl, R₂ is hydrogen or methyl, and n is an integer from 1 to 5.

2. Process for preparing a rubber precursor or a rubber composition according to claim 1 wherein in step a) a mixture is prepared of an aqueous suspension of inorganic particulate material and a first solvent being an alkoxylated alcohol according to the formula: 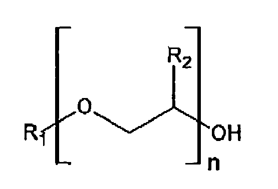 wherein R₁ is a C₁-C₄ alkyl, R₂ is hydrogen or methyl, and n is an integer from 1 to 5,
and wherein after step b) at least one coupling agent is contacted with the mixture and the inorganic oxygen-containing particulate material is at least partially modified.

3. Rubber composition obtainable by a process according to claim 1 or 2 comprising rubber and inorganic oxygen-containing particulate material modified with a coupling agent, wherein the inorganic oxygen-containing particulate material has a dimension of between 1 and 1,000 nm in at least one direction.

4. Rubber composition according to claim 3 wherein the coupling agent comprises a functional group reactive with the particulate material and an organic group reactive with the rubber or with a rubber precursor.

5. Masterbatch obtainable by a process according to claim 1 or 2 comprising a rubber precursor and an inorganic oxygen-containing particulate material having a dimension of between 1 and 1,000 nm in at least one direction, which particulate material is modified with a coupling agent wherein the amount of particulate material is between 5 and 80 wt%, based on the total weight of the masterbatch, and the amount of rubber precursor is between 20 and 95 wt%.

6. Masterbatch according to claim 5 wherein the coupling agent comprises a functional group reactive with the particulate material and an organic group reactive with the rubber or with the rubber precursor.

7. Solar cell unit comprising a layered structure comprising a back electrode, a photovoltaic layer, a front electrode, and a transparent top layer wherein a layer of the rubber composition according to either of claims 3-4 is present in between the front electrode and the transparent top layer, wherein the rubber is a transparent rubber composition, preferably a silicone rubber.

8. Use of the rubber composition according to either of claims 3 and 4 in solar cell units, the rubber preferably being a silicone rubber.

## Patentansprüche

1. Verfahren zur Herstellung eines Gummivorläufers oder einer Gummizusammensetzung, umfassend die Schritte:
a) Herstellen einer Mischung aus dem modifizierten anorganischen sauerstoffhaltigen partikulärem Material und einem ersten Lösungsmittel; und
b1) in Kontakt bringen der Mischung mit einem Gummivorläufer, welcher zumindest ein Polymer und gegebenenfalls ein zweites Lösungsmittel umfasst; oder
b2) in Kontakt bringen der Mischung mit einer Monomerzusammensetzung, welche mindestens ein Monomer und gegebenenfalls ein zweites Lösungsmittel umfasst, und Polymerisieren des Monomers / der Monomere, um den Gummivorläufer zu bilden;
c) gegebenenfalls Vernetzen des Gummivorläufers in der Gegenwart eines Vernetzungsmittels, um eine Gummizusammensetzung zu bilden; und
d) gegebenenfalls Entfernen des ersten und/oder zweiten Lösungsmittels während oder nach einem der Schritte b1), b2) und c),
wobei die ersten und/oder zweiten Lösungsmittel alkoxylierte Alkohole gemäß der Formel: 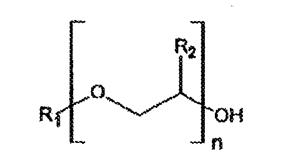 sind,
wobei R₁ C₁-C₄-Alkyl ist, R₂ Wasserstoff oder Methyl ist und n eine ganze Zahl von 1 bis 5 ist.

2. Verfahren zur Herstellung eines Gummivorläufers oder einer Gummizusammensetzung gemäß Anspruch 1, wobei in Schritt a) eine Mischung aus einer wässrigen Suspension von anorganischem partikulärem Material und einem ersten Lösungsmittel hergestellt wird, welches ein alkoxylierter Alkohol gemäß der Formel: 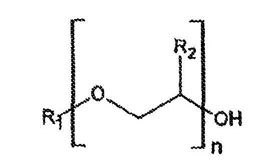 ist,
wobei R₁ C₁-C₄-Alkyl ist, R₂ Wasserstoff oder Methyl ist und n eine ganze Zahl von 1 bis 5 ist,
und wobei nach Schritt b) mindestens ein Kupplungsmittel in Kontakt mit der Mischung gebracht wird und das anorganische sauerstofffialtige partikuläre Material zumindest teilweise modifiziert wird.

3. Gummizusammensetzung, erhältlich durch ein Verfahren gemäß Anspruch 1 oder 2, umfassend Gummi und ein anorganisches sauerstofflialtiges partikuläres Material modifiziert mit einem Kupplungsmittel, wobei das anorganische sauerstofflialtige Material eine Abmessung zwischen 1 und 1000 nm in mindestens einer Richtung hat.

4. Gummizusammensetzung gemäß Anspruch 3, wobei das Kupplungsmittel eine funktionelle Gruppe umfasst, die mit dem partikulären Material umsetzbar ist, und eine organische Gruppe, die mit dem Gummi oder dem Gummivorläufer umsetzbar ist.

5. Masterbatch, erhältlich durch ein Verfahren gemäß einem der Ansprüche 1 oder 2, umfassend einen Gummivorläufer und ein anorganisches sauerstofffialtiges partikuläres Material mit einer Abmessung zwischen 1 und 1000 nm in wenigstens einer Richtung, dessen partikuläres Material mit einem Kupplungsmittel modifiziert ist, wobei die Menge von partikulärem Material zwischen 5 und 80 Gewichtsprozent, basierend auf dem Gesamtgewicht des Masterbatch, beträgt und die Menge des Gummivorläufers zwischen 20 und 95 Gewichtsprozent beträgt.

6. Masterbatch gemäß Anspruch 5, wobei das Kupplungsmittel eine funktionelle Gruppe umfasst, die mit dem partikulären Material umsetzbar ist, und eine organische Gruppe, die mit dem Gummi oder dem Gummivorläufer umsetzbar ist.

7. Solarzelleneinheit, umfassend eine Schichtstruktur umfassend eine Rückelektrode, ein photovoltaische Schicht, eine Vorderelektrode und eine transparente Deckschicht, wobei eine Schicht der Gummizusammensetzung gemäß einem der Ansprüche 3 bis 4 zwischen der Vorderelektrode und der transparenten Deckschicht vorliegt, wobei der Gummi eine transparente Gummizusammensetzung, vorzugsweise ein Silikongummi, ist.

8. Verwendung der Gummizusammensetzung gemäß einem der Ansprüche 3 und 4 in Solarzelleinheiten, wobei der Gummi vorzugsweise ein Silikongummi ist.

## Revendications

1. Procédé de préparation d'un précurseur de caoutchouc ou d'une composition de caoutchouc comprenant les étapes consistant à :
a) préparer un mélange du matériau particulaire contenant de l'oxygène inorganique modifié et d'un premier solvant ; et
b1) mettre en contact le mélange avec un précurseur de caoutchouc comprenant au moins un polymère et facultativement un second solvant ; ou
b2) mettre en contact le mélange avec une composition de monomère comprenant au moins un monomère et facultativement un second solvant, et polymériser le(s) monomère(s) pour former le précurseur de caoutchouc ;
c) facultativement réticuler le précurseur de caoutchouc en présence d'un agent de réticulation pour former une composition de caoutchouc ; et
d) facultativement éliminer le premier et/ou le second solvant pendant ou après l'une quelconque des étapes b1), b2) et c),
dans lequel le premier et/ou le second solvant sont des alcools alcoxylés selon la formule 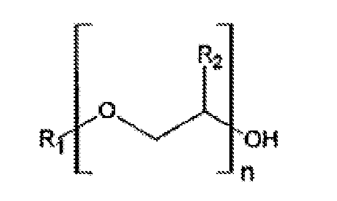 dans laquelle R₁ est un groupe alkyle en C₁ à C₄, R₂ est un atome d'hydrogène ou un groupe méthyle, et n est un entier de 1 à 5.

2. Procédé de préparation d'un précurseur de caoutchouc ou d'une composition de caoutchouc selon la revendication 1, dans lequel à l'étape a) un mélange est préparé à partir d'une suspension aqueuse de matériau particulaire inorganique et d'un premier solvant qui est un alcool alcoxylé selon la formule 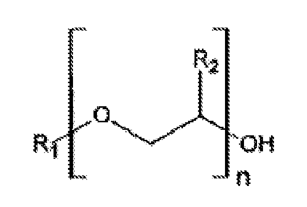 dans laquelle R₁ est un groupe alkyle en C₁ à C₄, R₂ est un atome d'hydrogène ou un groupe méthyle, et n est un entier de 1 à 5,
et dans lequel après l'étape b) au moins un agent de couplage est mis en contact avec le mélange et le matériau particulaire contenant de l'oxygène inorganique est au moins partiellement modifié.

3. Composition de caoutchouc pouvant être obtenue par un procédé selon la revendication 1 ou 2 comprenant du caoutchouc et un matériau particulaire contenant de l'oxygène inorganique modifié avec un agent de couplage, dans laquelle le matériau particulaire contenant de l'oxygène inorganique a une dimension comprise entre 1 et 1 000 nm dans au moins une direction.

4. Composition de caoutchouc selon la revendication 3, dans laquelle l'agent de couplage comprend un groupe fonctionnel réactif avec le matériau particulaire et un groupe organique réactif avec le caoutchouc ou avec un précurseur de caoutchouc.

5. Mélange maître pouvant être obtenu par un procédé selon la revendication 1 ou 2, comprenant un précurseur de caoutchouc et un matériau particulaire contenant de l'oxygène inorganique ayant une dimension comprise entre 1 et 1 000 nm dans au moins une direction, lequel matériau particulaire est modifié avec un agent de couplage où la quantité de matériau particulaire est comprise entre 5 et 80 % en poids, sur la base du poids total du mélange maître, et la quantité de précurseur de caoutchouc est comprise entre 20 et 95 % en poids.

6. Mélange maître selon la revendication 5, dans lequel l'agent de couplage comprend un groupe fonctionnel réactif avec le matériau particulaire et un groupe organique réactif avec le caoutchouc ou avec le précurseur de caoutchouc.

7. Unité de cellule solaire comprenant une structure en couches comprenant une électrode arrière, une couche photovoltaïque, une électrode avant, et une couche supérieure transparente où une couche de la composition de caoutchouc selon l'une ou l'autre des revendications 3 et 4 est présente entre l'électrode avant et la couche supérieure transparente, où le caoutchouc est une composition de caoutchouc transparente, de préférence un caoutchouc de silicone.

8. Utilisation de la composition de caoutchouc selon l'une ou l'autre des revendications 3 et 4 dans des unités de cellule solaire, le caoutchouc étant de préférence un caoutchouc de silicone.
